(19) Europäisches Patentamt
European Patent Office
Office européen des brevets

(11) **EP 2 869 072 A1**

(12) **EUROPÄISCHE PATENTANMELDUNG**

(43) Veröffentlichungstag:
06.05.2015  Patentblatt 2015/19

(51) Int Cl.:
**G01R 11/25** (2006.01)     **G01R 35/02** (2006.01)

(21) Anmeldenummer: **14003690.6**

(22) Anmeldetag: **31.10.2014**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**

(30) Priorität: **01.11.2013   DE 102013018294**

(71) Anmelder: **Ean Elektroschaltanlagen GmbH
04668 Grimma (DE)**

(72) Erfinder: **Rathsmann, Stephan
03044 Cottbus (DE)**

(74) Vertreter: **Nourney, David et al
Knigge Nourney Böhm
Rechtsanwälte Wirtschaftsmediation
Partnerschaftsgesellschaft
Gohliser Straße 6
04105 Leipzig (DE)**

(54) **Einrichtung und Verfahren zur Erfassung der elektrischen Energie von ein- oder mehrphasigen Verbrauchern**

(57)     Die vorliegende Erfindung betrifft eine Einrichtung (1) zur Erfassung der elektrischen Energie von zumindest zwei ein- oder mehrphasigen elektrischen Verbrauchern (3), umfassend

- mindestens eine Messeinrichtung (5) zur Erfassung eines Stroms (I) und einer Spannung (U) der Verbraucher (3),
- mindestens einen Filter (7) zum Trennen des Stroms (I) in einen Prüfstrom ($I_P$) und einen Messstrom ($I_M$),
- mindestens eine Berechnungseinheit (9) zur Berechnung von aufgenommener elektrischer Leistung und/oder aufgenommener elektrischer Arbeit der zumindest zwei Verbraucher (3) und zur Erzeugung von verbraucherbezogenen Daten und
- mindestens eine Speichereinheit (11) zur Speicherung der verbraucherbezogenen Daten,

wobei die Messeinrichtung (5) einen Stromwandler (13) mit einem Spulenwiderstand ($R_S$), zumindest eine zu dem Spulenwiderstand ($R_S$) des Stromwandler (13) parallel geschaltete Spannungsquelle (15) zur Erzeugung des Prüfstromes ($I_P$) in jedem Messkreis für die Verbraucher (3), einen mit der Spannungsquelle (15) verbundenen Ankoppelwiderstand ($R_1$), einen zu dem Stromwandler (13) parallel geschalteten Bürdewiderstand ($R_B$), und einen Messverstärker (17), der mit dem Filter (7) verbunden ist, aufweist.

Ferner bezieht sich die vorliegende Erfindung auf Verfahren zur Erfassung der elektrischen Energie von zumindest zwei ein- oder mehrphasigen elektrischen Verbrauchern (3) mittels einer erfindungsgemäßen Einrichtung (1).

Fig. 1

**Beschreibung**

Die vorliegende Erfindung bezieht sich auf eine Einrichtung und ein Verfahren zur Erfassung der elektrischen Energie von zumindest zwei ein- oder mehrphasigen elektrischen Verbrauchern.

Aus dem Stand der Technik sind allgemein Sicherungsautomaten bekannt, die üblicherweise in einem sog. Elektrizitätszähler angeordnet sind und einen Stromkreis abschalten, wenn der Strom zu einem Verbraucher einen für die Leitung des Stromkreises unzulässigen Wert überschreitet. An solche herkömmlichen Elektrizitätszähler sind In der Regel eine Vielzahl von elektrischen Verbrauchern angeschlossen, die über getrennte Stromkreise versorgt werden. Üblicherweise wird für jeden Stromkreis ein Sicherungsautomat vorgesehen. Der Elektrizitätszähler zeigt den Gesamtverbrauch der elektrischen Arbeit aller Verbraucher an, eine Aufschlüsselung nach einzelnen Verbrauchern ist nicht möglich.

Gattungsgemäße Einrichtungen und Verfahren sind aus dem Stand der Technik ebenfalls bekannt. So beschreibt DE 102007 047 920 A1 eine Einrichtung zur Erfassung der elektrischen Energie zumindest eines elektrischen Verbrauchers mit Messeinrichtungen zur Erfassung von Strom und Spannung des zu versorgenden Verbrauchers, Berechnungseinheit zur Berechnung von aufgenommener elektrischer Leistung und/oder Arbeit sowie Speichereinheit zur Speicherung der ermittelten Daten. Diese Einrichtung ist dazu vorgesehen, den Energieverbrauch elektrische Verbraucher auf einfache Weise zu erfassen, zu steuern und zu optimieren. Leitungsbrüche und/oder Kurzschlüsse in den elektrischen Verbrauchern können somit festgestellt werden.

Nachteilig am Stand der Technik ist jedoch, dass ein Leitungsbruch und/oder ein Kurzschluss in der Messeinrichtung selbst, die zur Erfassung von Strom und Spannung dient, nicht erkannt werden kann. Tritt folglich in der Messeinrichtung selbst ein Leitungsbruch und/oder ein Kurzschluss auf, ist damit ihr zweckmäßiger Betrieb nicht mehr gewährleistet. Dies kann bei den zu überwachenden elektrischen Verbrauchern zu teilweise gravierenden Störungen führen.

Ausgehend von den vorstehend genannten Nachteilen des Standes der Technik liegt der vorliegenden Erfindung die Aufgabe zugrunde, eine betriebssichere und vollständige Überwachung für Leitungsbruch und/oder Kurzschluss in Jedem Messkreis zur Erfassung des Stroms und einen fehlerfreien Anschluss der Stromwandler der zu überwachenden Verbraucher bereitzustellen.

Diese Aufgabe wird in einem ersten Aspekt der vorliegenden Erfindung durch eine Einrichtung (1) zur Erfassung der elektrischen Energie von zumindest zwei ein- oder mehrphasigen elektrischen Verbrauchern (3) gelöst, die umfasst:

- mindestens eine Strommesseinrichtung (5) zur Erfassung eines Stroms (I) der Verbraucher (3),
- mindestens eine Spannungsmesseinrichtung (V) zur Erfassung einer Spannung (U) der Verbraucher (3),
- mindestens einen Filter (7) zum Trennen des Stroms (I) in einen Prüfstrom ($I_P$) und einen Messstrom ($I_M$),
- mindestens eine Berechnungseinheit (9) zur Berechnung von aufgenommener elektrischer Leistung und/oder aufgenommener elektrischer Arbeit der zumindest zwei Verbraucher (3) und zur Erzeugung von verbraucherbezogenen Daten und
- mindestens eine Speichereinheit (11) zur Speicherung der verbraucherbezogenen Daten,

wobei die Strommesseinrichtung (5) einen Stromwandler (13) mit einem Spulenwiderstand ($R_S$), zumindest eine zu dem Spulenwiderstand (Rs) des Stromwandlers (13) parallel geschaltete Spannungsquelle (15) zur Erzeugung des Prüfstroms ($I_P$) in jedem Messkreis für die Verbraucher (3), einen mit der Spannungsquelle (15) verbundenen Ankoppelwiderstand ($R_1$), einen zu dem Stromwandler (13) parallel geschalteten Bürdewiderstand ($R_B$) und einen Messverstärker (17), der mit dem Filter (7) verbunden ist, aufweist.

In einem zweiten Aspekt der vorliegenden Erfindung wird diese Aufgabe durch ein Verfahren zur Erfassung der elektrischen Energie von zumindest zwei ein- oder mehrphasigen elektrischen Verbrauchern (3) mittels einer erfindungsgemäßen Einrichtung (1) gelöst, das die Schritte umfasst

a) Anlegen einer Spannung (U) an eine Sekundärspule eines Stromwandlers (13) und Erzeugen eines resultierenden Stroms ($I_S$),
b) Ermitteln eines Spulenwiderstands (Rs) der Sekundärspule aus dem resultierenden Strom ($I_S$),
c) Überwachung des Spulenwiderstands ($R_S$) und
d) Überwachung und Auswertung der Polarität der elektrischen Leistung der zumindest zwei Verbraucher (3).

In einem dritten Aspekt der vorliegenden Erfindung wird diese Aufgabe durch ein Verfahren zur Erfassung der elektrischen Energie von zumindest zwei ein- oder mehrphasigen elektrischen Verbrauchern (3) mittels einer Einrichtung (1) nach einem der Ansprüche 1 bis 3 gelöst, das die Schritte umfasst

aa) Anlegen eines Gleichstroms (I) an eine Sekundärspule eines Stromwandlers (13) und Erzeugen eines Spannungsabfalls ($\Delta U$),
bb) Ermitteln eines Spulenwiderstands ($R_S$) der Sekundärspule aus dem Spannungsabfall ($\Delta U$),
c) Überwachung des Spulenwiderstands ($R_S$) und
d) Überwachung und Auswertung der Polarität der elektrischen Leistung der zumindest zwei Verbraucher (3).

Die erfindungsgemäße Einrichtung (1) und die erfindungsgemäßen Verfahren zeigen gegenüber dem bekannten Stand der Technik den Vorteil, dass es erstmals möglich ist, mit einer einzigen Einrichtung (1) bzw. einem einzigen Verfahren sowohl eine Laststrommessung als auch eine Differenzstrommessung in jedem Strommesskanal, bzw. Jedem Strommesskreis mit Verbrauchern (3) durchzuführen. Ferner kann ein fehlerfreier Anschluss der Stromwandler der Verbraucher (3) sichergestellt werden.

Nachfolgend wird die vorliegende Erfindung detailliert beschrieben.

Sofern im Zusammenhang mit der erfindungsgemäßen Einrichtung (1) Verfahrensmerkmale beschrieben werden, so beziehen sich diese insbesondere auf die erfindungsgemäßen Verfahren, wie sie nachstehend definiert werden. Wenn In der Beschreibung der erfindungsgemäßen Verfahren gegenständliche Merkmale ausgeführt werden, so beziehen sich diese Insbesondere auf die erfindungsgemäße Einrichtung (1), wie sie nachstehend beschrieben wird.

Die Erfindung bezieht sich zunächst auf eine Einrichtung (1) zur Erfassung der elektrischen Energie von zumindest zwei ein- oder mehrphasigen elektrischen Verbrauchern (3). Die Einrichtung (1) umfasst

- mindestens eine Strommesseinrichtung (5) zur Erfassung eines Stroms (I) der Verbraucher (3),
- mindestens eine Spannungsmesseinrichtung (V) zur Erfassung einer Spannung (U) der Verbraucher (3),
- mindestens einen Filter (7) zum Trennen des Stroms (I) in einen Prüfstrom ($I_P$) und einen Messstrom ($I_M$).
- mindestens eine Berechnungseinheit (9) zur Berechnung von aufgenommener elektrischer Leistung und/oder aufgenommener elektrischer Arbeit der zumindest zwei Verbraucher (3) und zur Erzeugung von verbraucherbezogenen Daten und
- mindestens eine Speichereinheit (11) zur Speicherung der verbraucherbezogenen Daten.

Dabei weist die Strommesseinrichtung (5) einen Stromwandler (13) mit einem Spulenwiderstand ($R_S$), zumindest eine zu dem Spulenwiderstand (Rs) des Stromwandlers (13) parallel geschaltete Spannungsquelle (15) zur Erzeugung des Prüfstroms ($I_P$) in jedem Messkreis für die Verbraucher (3), einen mit der Spannungsquelle (15) verbundenen Ankoppelwiderstand ($R_1$), einen zu dem Stromwandler (13) parallel geschalteten Bürdewiderstand ($R_B$) und einen Messverstärker (17), der mit dem Filter (7) verbunden Ist, auf.

Mit "Strommesseinrichtung" und "Spannungsmesseinrichtung" werden im Sinne der Erfindung Geräte bezeichnet, die einer elektrischen Anlage zum Zweck der Energiezählung und Verbraucher bzw. Anlagenüberwachung hinzugefügt werden.

Der Begriff "Filter" beschreibt in der vorliegenden Erfindung das Element, welches das Ausgangssignal des Messverstärkers (17) in ein Prüfsignal und ein Messsignal auftrennt, wobei das Prüfsignal die vom Prüfstrom verursachte und das Messsignal die vom Messstrom verursachte Komponente bezeichnen.

Unter "Prüfstrom ($I_P$)" und "Messstrom ($I_M$)" werden nachfolgend die beiden Stromkomponenten verstanden, die von der Messeinrichtung (5) selbst bzw. vom Primärstrom des Stromwandlers (13) verursacht werden.

Die "Berechnungseinheit" ist gemäß der Erfindung das Element, welches aus dem Messsignal vom Filter (7) und einem Spannungssignal von der Spannungsmesseinrichtung (V) die elektrischen Kenngrößen der Verbraucher (3) berechnet. Mit der Berechnungseinheit (9) werden insbesondere die aufgenommenen, bzw. ermittelten Wirk-, Blind- und Scheinleistungen und / oder die elektrische Arbeit, der Betrag und der Phasenwinkel der Spannungen und Ströme, der Leistungsfaktor, die Phasenverschiebung, der Scheitelfaktor und der Klirrfaktor aller Spannungen und Ströme sowie der Fehlerstrom jedes elektrischen Verbrauchers (3) bestimmt. Erfindungsgemäß kann die Berechnungseinheit (9) in eine erste Berechnungseinheit (9a) zur Berechnung des Wandlerwiderstands ($R_S$) und eine zweite Berechnungseinheit (9b) zur Netzberechnung unterteilt sein.

Mit "Stromwandler" wird im Sinne der Erfindung ein Messwandler zum potentialfreien Messen von Wechselströmen bezeichnet. Stromwandler sind dem Fachmann prinzipiell bekannt.

Der "Ankoppelwiderstand" bezeichnet das Element zur Ankopplung der Prüfspannungsquelle (15) an einen Sekundärstromkreis, während der "Bürdewiderstand ($R_B$)" das Element zur Messung des Sekundärstroms bezeichnet. Der Begriff "Bürdewiderstand" ist dem Fachmann bekannt.

Der "Sekundärstrom" Ist gemäß der Erfindung, der vom Messverstärker (17) gemessene Strom, der die Summe der beiden Komponenten Prüfstrom ($I_P$) und Messstrom ($I_M$) ist.

Mit der erfindungsgemäßen Einrichtung (1) ist es in vorteilhafter Welse möglich, für eine Anzahl von zumindest zwei ein- oder mehrphasigen elektrischen Verbrauchern (3) über einen Strommesskanal, bzw. einen Strommesskreis sowohl einen Laststrom als auch einen Differenzstrom zu bestimmen. Darüber hinaus wird ein fehlerfreier Anschluss der Stromwandler der Verbraucher (3) gewährleistet.

In einer ersten Weiterbildung der vorliegenden Erfindung ist die Spannungsquelle (15) eine Gleichspannungsquelle. Da der Stromwandler (13) induktiv arbeitet, enthält der Messstrom ($I_M$) keinen Gleichanteil. Die Auftrennung des Messsignals durch den Filter (7) funktioniert erfindungsgemäß unabhängig vom Verbraucher (3). Der Filter (7) kann daher sehr einfach realisiert werden.

In einer zur ersten Weiterbildung alternativen zweiten Weiterbildung der vorliegenden Erfindung ist die Spannungsquelle (15) eine Wechselspannungsquelle, wobei die Wechselspannung eine Frequenz hat, die sich von der oder den Frequenzen des zumindest einen Verbrauchers (3) unterscheidet. Durch eine Auswertung der Phasenbeziehung von Prüfwechselspannung und Prüfstrom ($I_P$) lässt sich neben dem ohmschen Kupferwiderstand auch der induktive Blindwiderstand der Wandlerspule ermitteln. Bei Stromwandlern (13) mit teilbarem Kern kann so am Wert des Bündwiderstands erkannt werden, ob der Kern korrekt geschlossen ist oder nicht.

Die Erfindung bezieht sich ferner auf ein Verfahren zur Erfassung der elektrischen Energie von zumindest zwei ein- oder mehrphasigen elektrischen Verbrauchern (3) mittels einer Einrichtung (1), wie sie vorstehend definiert wurde. Das Verfahren umfasst die Schritte

a) Anlegen einer Spannung (U) an eine Sekundärspule eines Stromwandlers (13) und Erzeugen eines resultierenden Stroms ($I_S$),
b) Ermitteln eines Spulenwiderstands ($R_S$) der Sekundärspule aus dem resultierenden Strom ($I_S$),
c) Überwachung des Spulenwiderstands ($R_S$) und
d) Überwachung und Auswertung der Polarität der elektrischen Leistung der zumindest zwei Verbraucher (3).

Der In dem erfindungsgemäßen Verfahren erzeugte Prüfstrom ($I_P$) muss gering sein. Der Stromwandler (13) muss nämlich trotz des Prüfstromes ($I_P$) im linearen Bereich der Magnetisierungskurve B(H) des Eisenkerns der Spule betrieben werden. Andernfalls würden Verzerrungen des Messstroms ($I_M$) entstehen. Ist der Prüfstrom ($I_P$) ein Wechselstrom, könnten andernfalls Modulationseffekte auftreten.

Bevorzugt wird in dem vorstehenden Verfahren nach Schritt a) und vor Schritt b) das Einschwingen des resultierenden Stroms ($I_S$) abgewartet, um die Induktivität der Wandlerspule zu berücksichtigen. Erst nach dem Einschwingen liefert Rs = $\Delta U$ / $\Delta I$ den tatsächlichen Wert. Auch eine saubere Trennung der Signale durch den Filter (7) ist erst nach dem Einschwingvorgang möglich. Den sich einschwingenden Prüfstrom ($I_P$) würde der Filter (7) ansonsten als Wechselanteil behandeln.

Alternativ zu diesem Verfahren bezieht sich die Erfindung auf ein Verfahren zur Erfassung der elektrischen Energie von zumindest zwei ein- oder mehrphasigen elektrischen Verbrauchern (3). Das alternative Verfahren umfasst die Schritte

a) Anlegen eines Gleichstroms (I) an eine Sekundärspule eines Stromwandlers (13) und Erzeugen eines Spannungsabfalls ($\Delta U$),
b) Ermitteln eines Spulenwiderstands ($R_S$) der Sekundärspule aus dem Spannungsabfall ($\Delta U$),
c) Überwachung des Spulenwiderstands ($R_S$) und
d) Überwachung und Auswertung der Polarität der elektrischen Leistung der zumindest zwei Verbraucher (3).

Vorzugsweise wird das alternative Verfahren mittels einer Einrichtung durchgeführt, die im Wesentlichen der Einrichtung (1) entspricht, wie sie vorstehend definiert wurde.

In dem alternativen Verfahren ist bevorzugt, nach Schritt aa) und vor Schritt bb) das Einschwingen des Gleichstroms (I) abzuwarten, um die Induktivität der Wandlerspule zu berücksichtigen. Erst nach dem Einschwingen liefert Rs = $\Delta U$ / $\Delta I$ den tatsächlichen Wert. Auch eine saubere Trennung der Signale durch den Filter (7) ist erst nach dem Einschwingvorgang möglich. Den sich einschwingenden Prüfstrom ($I_P$) würde der Filter (7) ansonsten als Wechselanteil behandeln.

Das wesentliche Messprinzip der vorliegenden Erfindung beruht darauf, dass der Messverstärker (17) neben dem Messsignal noch ein weiteres, vom Gerät selbst verursachtes Prüfsignal mit misst, dessen Stärke vom Spulenwiderstand ($R_S$) abhängt. Es ist ferner wesentlich, dass das Messsignal und das Prüfsignal im Filter (7) wieder voneinander getrennt werden.

Der Ausdruck "Prüfsignal" wird Im vorliegenden Fall verwendet, da es erfindungsgemäß zwei Möglichkeiten zur Messung des Spulenwiderstands ($R_S$) gibt. Einerseits kann eine Spannung (U), d.h. eine Messspannung, an die Sekundärspule eines Stromwandlers (13) angelegt und dann der resultierende Strom ($I_S$), d.h. der Messstrom, gemessen werden. Andererseits kann ein Gleichstrom, d.h. ein Messgleichstrom, an die Sekundärspule eines Stromwandlers (13) angelegt und dann der Spannungsabfall ($\Delta U$) gemessen werden.

In den nachstehend beschriebenen Ausführungsbeispielen wird zudem gezeigt, dass erfindungsgemäß beide Verfahren miteinander eingesetzt werden können. Die erfindungsgemäße Reihenschaltung aus Spannungsquelle (15) und Ankoppelwiderstand ($R_1$) kann auch durch eine Parallelschaltung aus Stromquelle und Innenwiderstand (= Ankoppelwiderstand) ersetzt oder ergänzt werden (d.h. reale Spannungs- bzw. Stromquelle).

In einer Weiterbildung des erfindungsgemäßen Verfahrens wird in Schritt a) eine Gleichspannung ($U_G$) angelegt. Da der Stromwandler (13) induktiv arbeitet, enthält der Messstrom ($I_M$) keinen Gleichanteil. Die Auftrennung des Messsignals durch den Filter (7) funktioniert erfindungsgemäß unabhängig vom Verbraucher (3). Der Filter (7) kann daher sehr einfach realisiert werden.

Nach einer bevorzugten Ausführungsform kann Schritt b) die Teilschritte umfassen

b1) Trennen des resultierenden Stroms ($I_S$) in einen Messgleichstrom ($I_G$) und einen Messwechselstrom ($I_W$) mittels eines Filters (7),
b2) Ermitteln des Spulenwiderstands (Rs) aus dem Messgleichstrom ($I_G$) und der angelegten Gleichspannung ($U_G$).

Ferner kann nach einer anderen Ausführungsform Schritt c) erfindungsgemäß die Teilschritte umfassen

c1) Festlegen eines tolerierbaren Bereichs ($\Delta R_S$) des Spulenwiderstands ($R_S$),
c2) Abgleichen des In Schritt b) ermittelten Spulenwiderstands ($R_S$) mit dem tolerierbaren Bereich ($\Delta R_S$),
c3) Ausgeben zumindest eines Signals, falls der ermittelte Spulenwiderstand ($R_S$) außerhalb des tolerierbaren Bereich ($\Delta R_S$) liegt.

In Schritt d) der beiden vorstehend beschriebenen, erfindungsgemäßen Verfahren wird die Polarität der elektrischen Leistung ausgewertet. Wird für die elektrische Leistung ein negativer Wert ermittelt (positive Spannung und negativer Strom ergibt negative Leistung), so ist der Stromwandler (13) fehlerhaft angeschlossen. Folglich kann mit dem erfindungsgemäßen Verfahren, bzw. mit der erfindungsgemäßen Einrichtung (1) festgestellt werden, ob der Stromwandler (13) richtig angeschlossen ist.

In einer alternativen Weiterbildung des erfindungsgemäßen Verfahrens wird in Schritt a) eine Wechselspannung angelegt, die eine Frequenz hat, die sich von der oder den Frequenzen des zumindest einen Verbrauchers (3) unterscheidet. Durch eine Auswertung der Phasenbeziehung von Prüfwechselspannung und Prüfstrom ($I_P$) lässt sich neben dem ohmschen Kupferwiderstand auch der induktive Blindwiderstand der Wandlerspule ermitteln. Bei Stromwandlern (13) mit teilbarem Kern kann so am Wert des Blindwiderstands erkannt werden, ob der Kern korrekt geschlossen ist oder nicht.

Bei der Wahl der Frequenz ist es wichtig, dass eine Frequenz gewählt wird, die im zu überwachenden Netz nicht vorkommt. Hierzu ist ferner ein entsprechender Frequenzfilter vorzusehen. Auch in diesem Fall wird eine Spannung angelegt und der resultierende Strom gemessen.

Weitere Ziele, Merkmale, Vorteile und Anwendungsmöglichkeiten ergeben sich aus der nachfolgenden Beschreibung von die Erfindung nicht einschränkenden Ausführungsbeispielen anhand der Figuren. Dabei bilden alle beschriebenen und/oder bildlich dargestellten Merkmale für sich oder in beliebiger Kombination den Gegenstand der Erfindung, auch unabhängig von ihrer Zusammenfassung in den Ansprüchen oder deren Rückbeziehung.

Es zeigen:

Fig. 1 ein Blockschaltbild einer erfindungsgemäßen Einrichtung 1 nach einer Ausführungsform der Erfindung,

Fig. 2 eine schematische Darstellung einer erfindungsgemäßen Messeinrichtung 5 nach einer bevorzugten Ausführungsform der Erfindung,

Fig. 3a eine schematische Darstellung einer Messeinrichtung 5 nach einer alternativen Ausführungsform der Erfindung,

Fig. 3b eine schematische Darstellung einer Messeinrichtung 5 nach einer weiteren alternativen Ausführungsform der Erfindung und

Fig. 3c eine schematische Darstellung einer Messeinrichtung 5 nach noch einer weiteren alternativen Ausführungsform der Erfindung.

Die erfindungsgemäße Einrichtung 1 ermöglicht im Wesentlichen die Erfassung aller Spannungen eines Netzes und die Erfassung des Betriebs- und/oder Differenzstroms für jeden Verbraucher 3. Dabei wird In der Einrichtung 1 zur Erfassung des Stroms über eine Gleichspannungsquelle 15 in einem Messkreis für Strom ein Messgleichstrom $I_G$ erzeugt, der zusammen mit einem Messstrom $I_M$ in der Stromerfassung der Einrichtung 1 erfasst wird. Hierzu ist nach der Stromerfassung ein Filter 7 angeordnet, der den Messstrom $I_M$ und den Messgleichstrom $I_G$ voneinander trennt. So werden der Messstrom $I_M$ und der Messgleichstrom $I_G$ getrennt voneinander erfasst. Aus dem Messgleichstrom $I_G$ und der Spannung U der Gleichspannungsquelle 15 wird der Widerstand R der Stromerfassung, bestehend aus Messleitungen, Innenwiderstand des Stromwandlers 13 und Bürdewiderstand Re ermittelt. In Auswertung des Widerstands Rs wird ein Leitungsbruch und/oder ein Kurzschluss der Stromerfassung erkannt.

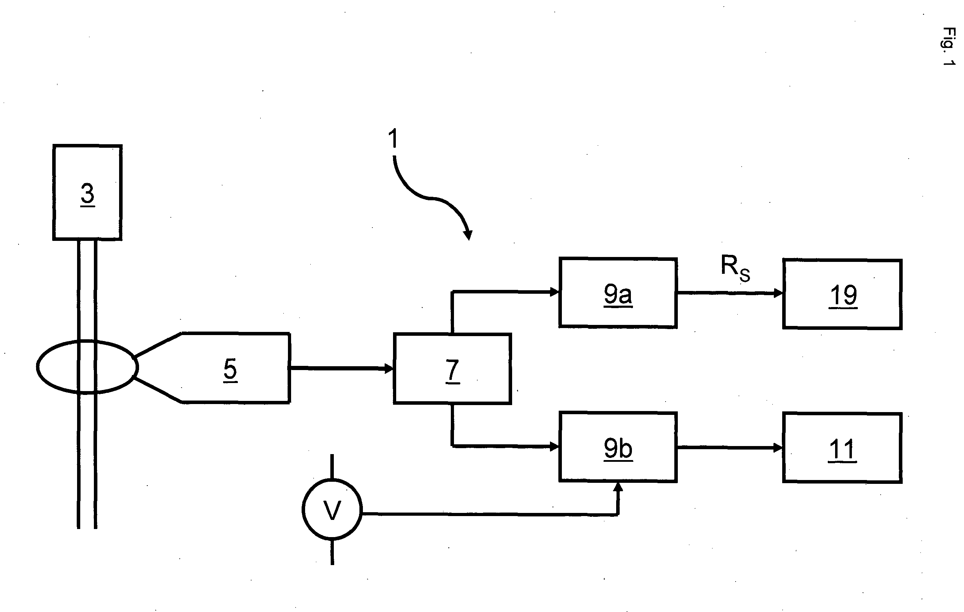

Fig. 1 stellt ein Blockschaltbild einer erfindungsgemäßen Einrichtung 1 nach einer Ausführungsform der Erfindung dar. Die Strommesseinrichtung 5 ist mit einer Wandlerspule im Leitungsnetz eines elektrischen Verbrauchers 3 angeordnet. Die mit der Strommesseinrichtung 5 erzeugten Signale werden in einem Filter 7 in einen Gleichstromanteil $I_G$ und einen Wechselstromanteil $I_W$ geteilt.

Der Gleichstromanteil $I_G$ wird einer ersten Berechnungseinheit 9a zugeführt, in der die Berechnung des Wandlerwiderstands $R_S$ durchgeführt wird. Dieser Wandierwiderstand $R_S$ wird auch als Kupferwiderstand $R_{Cu}$ bezeichnet. Er ergibt sich aus $R_{Cu} = U_P / J_G$. Der Wandlerwidarstand Rs wird einer Sollbereichsprüfung 19 zugeführt, in der der Wandlerwiderstand $R_S$ mit Minimal- und Maximalwerten des zulässigen Widerstands abgeglichen wird. Praktisch wird bel einem Wandlerwiderstand $R_S$ von kleiner 3 Ohm einen Kurzschluss anzeigt ($R_{min}$), während für einen Spulenwiderstand $R_S$ größer 20 Ohm ein Leitungsbruch angezeigt wird ($R_{max}$). Bei Über- oder Unterschreiten dieser Werte wird eine Fehlermeldung ausgegeben.

Der Wechselstromanteil $I_W$ wird einer Berechnungseinheit 9b zugeführt, in der die Netzberechnung stattfindet. Die hier gewonnenen Daten zu Effektivstrom, Leistung, etc. werden In einer Speichereinheit 11 abgelegt. Der Berechnungseinheit 9b werden zudem die Netzspannungen der Verbraucher 3 zugeführt, die von der Spannungsmesseinrichtung V erfasst werden.

Wie vorstehend bereits ausgeführt, gibt es erfindungsgemäß zwei Möglichkeiten zur Messung des Spulenwiderstands $R_S$: einerseits mittels Anlegen einer Messspannung an die Sekundärspule eines Stromwandlers 13 und Messen des resultierenden Messstroms $I_M$, andererseits mittels Anlegen eines Messgleichstroms $I_G$ an die Sekundärspule eines Stromwandlers 13 und Messen des Spannungsabfalls $\Delta U$.

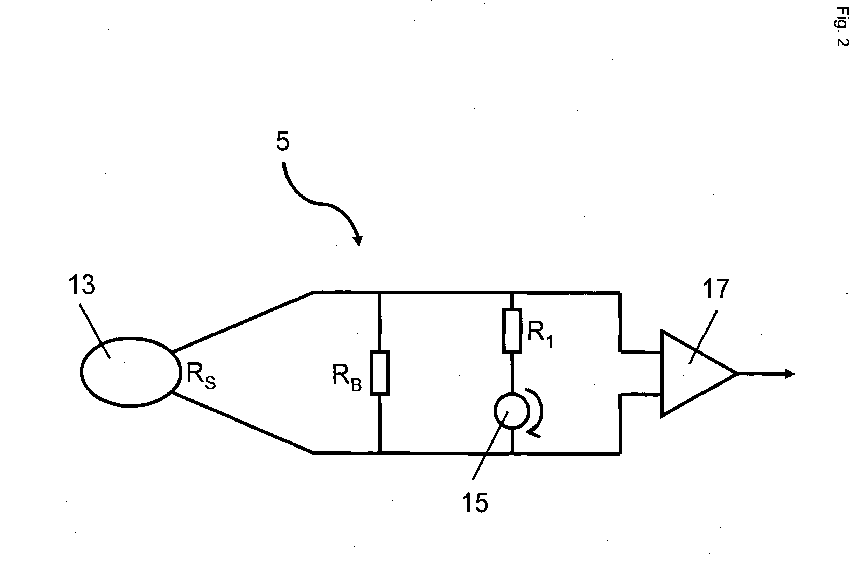

Fig. 2 stellt die Strommesseinrichtung 5 schematisch dar. An der Wandlerspule 13 fällt der Widerstand Rs ab. Der Spannungsquelle 15 mit dem Ankoppelwiderstand $R_1$ ist der Bürdewiderstand $R_B$ parallel geschaltet. Die erzeugten Ströme werden durch einen Messverstärker 17 zu dem in Fig. 2 nicht dargestellten Filter 7 ausgegeben.

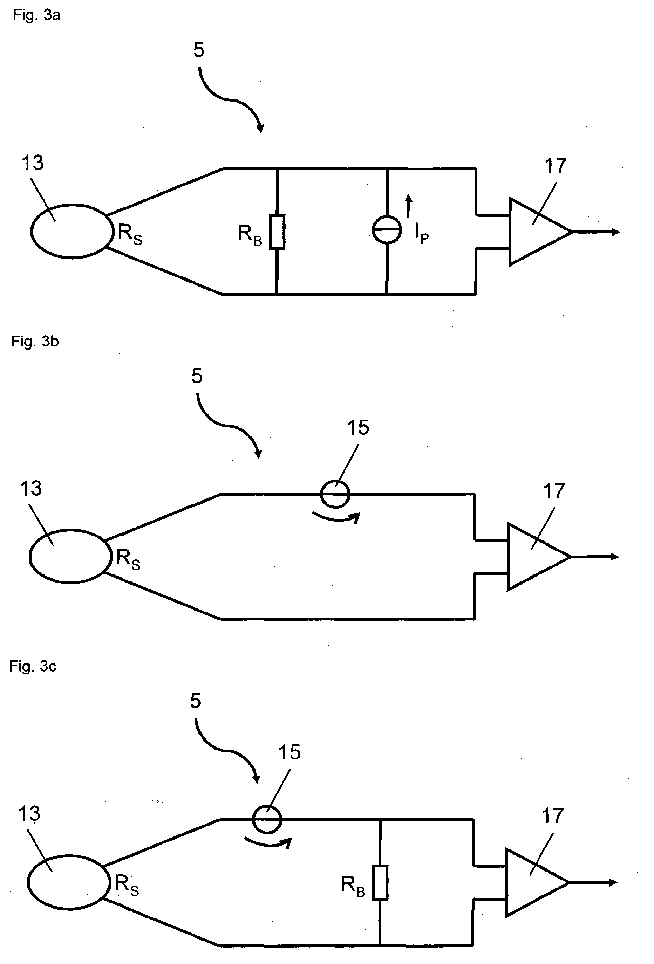

Alternative Ausführungsformen der Erfindung realisieren zwischen diesen beiden Möglichkeiten liegende Aufbauten, wie die in Fig. 3a, Fig. 3b und Fig. 3c dargestellt sind. Dabei kann auch der Messverstärker 17 einen Spannungs- oder Stromeingang haben, so dass der Bürdewiderstand $R_B$ nötig ist oder nicht. Als Prüfsignal kann im Wesentlichen jedes Signal verwendet werden, das sich mit einem Filter 7 wieder abtrennen lässt. Selbst eine Mischsignal (Gleich und Wechsel) ist realisierbar.

Nach einer weiteren Ausführungsform kann die Messung der Messgleichspannung bzw. der Messwechselspannung entfallen, wenn als Spannungsquelle 15 eine Konstant-Spannungsquelle vorgesehen wird.

Zur normalen Strommessfunktion, welche die Einrichtung 1 ermöglicht, gehören der Bürdewiderstand $R_B$, der den Strom vom Wandler 13 in eine Spannung umsetzt, und der Messverstärker 17, der diese Spannung verarbeitet.

Zu der durch die erfindungsgemäße Einrichtung 1 möglichen Anschlussüberwachung gehören die Gleichspannungsquelle 15 und der Ankoppelwiderstand $R_1$. Der Widerstand $R_S$ (Kupferwiderstand) der Wandlerspule Ist Teil eines Spannungsteilers. Weicht der Widerstand $R_S$ vom Sollwert (Sollbereich) ab, ändert sich der Gleichspannungsanteil in Ui entsprechend.

Die erfindungsgemäße Einrichtung 1 zeichnet sich auch dadurch aus, dass sie die Stromwandleranschlussüberwachung mit vollständiger RCM-Funktionalität gewährleistet.

Die erfindungsgemäßen Verfahren zeichnen sich zusammen mit der erfindungsgemäßen Einrichtung 1 zudem dadurch aus, dass ein fehlerfreier Anschluss der Stromwandler der zu überwachenden Verbraucher (3) sichergestellt wird.

Ausführungsbeispiel

Nachfolgend wird die vorliegende Erfindung anhand eines konkreten Ausführungsbeispiels der Einrichtung 1 beschrieben.

Funktion

Die Einrichtung 1 überwacht ein- und dreiphasige Verbraucher in 50 Hz-Versorgungsnetzen mit 230 V-Sternspannung. Sie verfügt über einen dreiphasigen Netzspannungsanschluss und 20 Stromwandieranschlüsse. Sie ist insbesondere dazu ausgelegt, folgende Größen zuermitteln:

- Stern- und Außenleiterspannungen des Netzes
- Betrag und Phasenwinkel der Grundschwingungen der Spannungen
- Scheinströme (Betriebsströme) der Verbraucher
- Betrag und Phasenwinkel der Grundschwingungen der Ströme
- Wirk-, Blind- und Scheinleistung
- Wirkarbeit
- Leistungsfaktor
- $\cos(\varphi)$
- Soheitelfaktor (Crest-Faktor) aller Spannungen und Ströme
- Klirrfaktor aller Spannungen und Ströme
- Harmonische aller Spannungen und Ströme
- Netzfrequenz
- Fehlerströme der Verbraucher

Die Einrichtung 1 speichert die aufgetretenen Minimal- und Maximalwerte mit Zeitstempel von Scheinstrom und Wirkleistung. Sie verfügt in dieser speziellen Ausführungsform über sieben einstellbare Summierkanäle mit denen es Wirkleistung und Wirkarbeit von Verbrauchergruppen ermitteln kann. So können z.B. die Summen von dreiphasigen Verbrauchern ermittelt werden.

Die Einrichtung 1 überwacht alle Scheinströme auf die Einhaltung vorgegebener Grenzwerte. Für jeden Strom lässt sich also ein zulässiger Maximal- und/oder Minimalwert einstellen. Liegt der Strom außerhalb des Sollbereichs, werden Überstrom- bzw. Unterstrom-Störmeldungen erzeugt. Für das Setzen und Rücksetzen der Störmeldungen sind Verzögerungszeit und Hysterese für jeden Kanal einstellbar. Neben den beiden Ansprechschwellen für die Überstrom- und Unterstrom-Störmeldungen können noch Warnschwellen für Überstrom- und Unterstrom-Warnmeldungen eingestellt werden.

Alle Messwerte, Betriebszustände und Parameter sind über eine RS485-Schnittstelle mit Modbus-RTU sowie eine Kommandozeile zugänglich. Die Einrichtung 1 verfügt außerdem über eine CAN-Schnittstelle, für die ein Protokoll zur Kommunikation mit anderen handelsüblichen Geräten vorgesehen ist. Die Überstrom- und Unterstrom-Meldungen können zusätzlich über zwei Digitalausgänge ausgegeben werden. Welche Stromkanäle und Meldungen für die beiden Ausgangssignale zusammengezogen werden, Ist einstellbar. Die Strommeldungen werden auch über LEDs angezeigt.

Die Einrichtung 1 kann Phasenverschiebungen des Stromsignals, die z.B. bei preiswerten, teilbaren Stromwandlern auftreten, kompensieren. Dadurch ist auch mit solchen Wandlern eine exakte Trennung von Wirk- und Blindleistung möglich.

Funktionsbeschreibung

Messfunktion

Die Einrichtung 1 misst die Effektivwerte der Sternspannungen (L-N) und der Außenleiterspannungen (L-L). Für jeden Stromkanal misst sie den Effektivwert das Scheinstroms I, die Wirkleistungen P und die Wirkarbeit W. Daraus berechnet sie:

Scheinleistung zu $S=U*I$
Bei negativer Wirkleistung und/oder Scheinleistung wird ein Fehlersignal erzeugt, das die Falschpolung des Stromwandlers 13 anzeigt.

Blindleistung zu $Q=\sqrt{S^2-P^2}$

Leistungsfaktor zu $K=\dfrac{P}{S}$

Für alle Spannungen und Ströme misst die Einrichtung 1 den Betrag und den Phasenwinkel der Grundschwingung. Der Betrag wird als Effektivwert angegeben. Die Winkel aller Spannungskanäle beziehen sich auf die Sternspannung U1 (L1-N). Der Phasenwinkel eines Stromkanals bezieht sich auf den ihm zugeordneten Spannungskanal. Ein Phasenwinkel wird positiv wenn die Messgröße der Bezugsgröße vorauseilt. Ein positiver Winkel bei einem Stromkanal bedeutet kapazitive Last. Neben dem Phasenwinkel φ eines Stromkanals berechnet die Einrichtung 1 den cos(φ),

Aus dem zeitlichen Verkauf des Stroms über eine Periode ermittelt die Einrichtung 1:

Scheitelfaktor (Crest-Faktor) zu $Ks=\dfrac{Is}{I}$

Is - Spitzenwert des Stroms

Harmonischenanteil (n = 1 - 30) zu

$$Hn=\frac{In}{I}*100$$

In - Effektivwert der Harmonischen

Klirrfaktor zu $Kf=\dfrac{\sqrt{\sum\limits_{n=2}^{30} In^2}}{I}$

n = 2 - 30 - Oberschwingungen

Diese Kennwerte werden mit Hilfe eines Analysekanals ermittelt, der auf jeden Strom- oder Spannungskanal (U1, U2, U3, U12, U23, U31) gerichtet werden kann.

Die Einrichtung 1 hat sieben Summierkanäle, mit denen sich Wirkleistung und Wirkarbeit beliebiger Stromkanäle addieren lassen.

Wandleranschlussüberwachung

Die Einrichtung 1 misst und überwacht den ohmschen Widerstand an jedem stromwandleranschluss. Dieser besteht gewöhnlich aus der Parallelschaltung des Kupferwiderstands der Sekundärspule und des Berdewiderstands. Liefert der Wandler keinen Sekundärstrom und liegt der Widerstand außerhalb eines Sollbereichs, meldet die Einrichtung 1 einen Anschlussfehler. Ist an einem Stramwandlerschluss nur der Wandler und kein Bürdewiderstand angeschlossen (Fehlerstrommessung), beträgt der Sollbereich ca. 3 bis 20 Ohm. Die Überwachung reagiert somit auf Leitungsbruch und Kurzschluss. Ist ein Bürdewiderstand vorhanden, reagiert sie nur auf Leitungsbruch.

Grenzwsrtoberwachung

Die Einrichtung 1 führt für alle Scheinströme eine Grenzwertüberwachung durch, die über folgende Parameter einstellbar ist:

- Überstromstörschwelle
- Überstromwamschwelle
- Unterstromwarrischwelle
- Unterstromstörschwelle
- Hysterese
- Ansprechverzögerung
- Rücksetzverzögerung

Überschreitet ein Strom für die Dauer der Ansprechverzögerung die Überstromstörschwelle, gibt die Einrichtung 1 eine Überstromstörmeldung. Unterschreitet der Strom anschließend für die Dauer der Rücksetzverzögerung den Wert (Überstramstorschwelle - Hysterese), setzt die Einrichtung 1 die Meldung wieder zurück. Die Unterstromstörmeldung funktioniert analog mit dem Rücksetzwert (Unterstromstörschwelle + Hysterese). Die Warnmeldungen funktionieren wiederum wie die Störmeldungen.

Die Summierkanäle liefern ebenfalls diese vier Grenzwertmeldungen, ist z.B. die Überstromstörmeldung eines der summierten Stromkanäle gesetzt, gibt die Einrichtung 1 eine Überstromstörmeldung für den Summierkanal.

Extremwertspeicherung

Die Einrichtung 1 speichert für jeden Stromkanal die aufgetretenen Minimal- und Maximalwerte von Scheinstrom und Wirkleistung mit Zeitstempel. Die gespeicherten Extremwerte werden kanalweise durch Befehle z.B. via Modbus oder durch einen Neustart der Einrichtung 1 zurückgesetzt. Die batteriegepufferte Uhr der Einrichtung 1 kann über Modbus gestellt werden.

Berechnung des Bürdewiderstands $R_B$

In der Regel sind der gewünschte Messbereich Imax und das Stromverhältnis N des Wandlers gegeben. Wichtig ist außerdem der zu erwartende Scheitelfaktor Ks. Ideal ist ein Scheitelfaktor von 1,41. Dieser Wert gilt für ohmsche Lasten, wird aber auch von Maschinen mit sog. Power Factor Correction erreicht. Mit einem hohen Scheitelfaktor ist zu rechnen, wenn die Verbraucher viele kleine Schaltnetzteile sind, bei denen PFC nicht vorgeschrieben ist. Eine Abschätzung des Scheitfaktor ist dann schwierig. Er hängt vom Aufbau der Netzteile und dem Innenwiderstand des Netzes vor dem Verbraucher ab. Als groben Richtwert kann man 3 annehmen. Der Bürdewiderstand $R_B$ ergibt sich aus:

$$Rb = \frac{1}{\frac{Imax * Ks}{N * Ues} - \frac{1}{Re}}$$

mit Ues und Re aus den technischen Daten unter Stromeingänge.

Bei Fehlerstrommessung entfällt der Bürdewiderstand $R_B$ wegen des kleinen Messbereichs.

Einstellung der Phasenkompensation

In der Regel kann die Phasenkompensation deaktiviert bleiben. Ein Phasenfehler tritt vor allem dann als Messfehler bei der Wirkleistung In Erscheinung, wenn der Verbraucher einen hohen Blindleistungsanteil hat. Eine hohe kapazitive Blindleistung erscheint bei Phasenfehler als negative Wirkleistung und wird auch entsprechend gezählt.

Ein Phasenfehler tritt vor allem bei teilbaren Wandlern wegen des Luftspalts auf. Im Verhältnis von Sekundärstrom zu Primärstrom zeigen solche Wandler ein Hochpassverhalten. Der Phasenfehler liegt z.B. bei CR3110-3000 um 5°. Dabei treten starke Exemplarstreuungen auf. Die Phasenkompensation des Stromkanals muss daher an den Wandler angepasst werden. Dazu muss der Kanal auf die untere Grenzfrequenz fg des Sekundärstromkreises aus Wandlerinduktivität L, Kupferwiderstand Rcu der Sekundärspule und Gesamtbürdewiderstand Rg derEinrichtung 1 eingestellt werden. Die Grenzfrequenz ergibt sich aus:

$$fg = \frac{Rg + Rcu}{2\pi * L} \quad \text{mit} \quad Rg = \frac{Re * Rb}{Re + Rb}$$

mit Re aus den technischen Daten unter Stromeingänge und Bürdewiderstand $R_B$.

Rcu lässt sich mit einem einfachen Multimeter ermitteln. L ermittelt man mit einem RLC-Meter bei niedriger Messfrequenz (100 Hz). Da man diese Messung nicht für jeden Wandler durchführen kann, ist es sinnvoll, einmalig 10 Exemplare eines Wandlertyps auszumessen, und sich einen Mittelwert für L zu bilden. Mit dem typspezifischen Mittelwert für L bzw. fg Ist die Kompensation nicht perfekt, aber die Messergebnisse sind besser als ohne Kompensation.

Bezugszeichen

1   Einrichtung
3   elektrischer Verbraucher
5   Strommesseinrichtung
7   Filter
9   Berechnungseinheit
11  Speichereinheit
13  Stromwandler
15  Spannungsquelle
17  Messverstärker (mit Aliasing-Filter)
19  Sollbereichsprüfung

V   Spannungsmesseinrichtung
$I_P$  Prüfstrom
$I_M$  Messstrom
$I_G$  Messgleichstrom
Rs  Spulenwiderstand
$R_{Cu}$  Kupferwiderstand
$R_1$  Ankoppelwiderstand der Spannungsquelle 15
$R_B$  Bürdewiderstand
Rb  Bürdewiderstand (Schreibweise für $R_B$ in den Formeln)
ΔU  Spannungsabfall

**Patentansprüche**

1.  Einrichtung (1) zur Erfassung der elektrischen Energie von zumindest zwei ein-oder mehrphasigen elektrischen Verbrauchern (3), umfassend

    - mindestens eine Strommesseinrichtung (5) zur Erfassung eines Stroms (I) der Verbraucher (3),
    - mindestens eine Spannungsmesseinrichtung (V) zur Erfassung einer Spannung (U) der Verbraucher (3),
    - mindestens einen Filter (7) zum Trennen des Stroms (I) in einen Prüfstrom ($I_P$) und einen Messstrom ($I_M$),
    - mindestens eine Berechnungseinheit (9) zur Berechnung von aufgenommener elektrischer Leistung und/oder aufgenommener elektrischer Arbeit der zumindest zwei Verbraucher (3) und zur Erzeugung von verbraucherbezogenen Daten und
    - mindestens eine Speichereinheit (11) zur Speicherung der verbraucherbezogenen Daten,

wobei die Strommesseinrichtung (5) einen Stromwandler (13) mit einem Spulenwiderstand ($R_S$), zumindest eine zu dem Spulenwiderstand ($R_S$) des Stromwandlers (13) parallel geschaltete Spannungsquelle (15) zur Erzeugung des Prüfstromes ($I_P$) in jedem Messkreis für die Verbraucher (3), einen mit der Spannungsquelle (15) verbundenen Ankoppelwiderstand ($R_1$), einen zu dem Stromwandler (13) parallel geschalteten Bürdewiderstand ($R_B$), und einen Messverstärker (17), der mit dem Filter (7) verbunden ist, aufweist.

2. Einrichtung (1) nach Anspruch 1, wobei die Spannungsquelle (15) eine Gleichspannungsquelle ist.

3. Einrichtung (1) nach Anspruch 1, wobei die Spannungsquelle (15) eine Wechselspannungsquelle ist, wobei die Wechselspannung eine Frequenz hat, die sich von der oder den Frequenzen des zumindest einen Verbrauchers (3) unterscheidet.

4. Verfahren zur Erfassung der elektrischen Energie von zumindest zwei ein- oder mehrphasigen elektrischen Verbrauchern (3) mittels einer Einrichtung (1) nach einem der Ansprüche 1 bis 3, umfassend die Schritte

   a) Anlegen einer Spannung (U) an eine Sekundärspule eines Stromwandlers (13) und Erzeugen eines resultierenden Stroms ($I_S$),
   b) Ermitteln eines Spulenwiderstands ($R_S$) der Sekundärspule aus dem resultierenden Strom ($I_S$),
   c) Überwachung des Spulenwiderstands (Rs) und
   d) Überwachung und Auswertung der Polarität der elektrischen Leistung der zumindest zwei Verbraucher (3).

5. Verfahren zur Erfassung der elektrischen Energie von zumindest zwei ein- oder mehrphasigen elektrischen Verbrauchern (3) mittels einer Einrichtung (1) nach einem der Ansprüche 1 bis 3, umfassend die Schritte

   aa) Anlegen eines Gleichstroms (I) an eine Sekundärspule eines Stromwandlers (13) und Erzeugen eines Spannungsabfalls ($\Delta U$),
   bb) Ermitteln eines Spulenwiderstands ($R_S$) der Sekundärspule aus dem Spannungsabfall ($\Delta U$),
   c) Überwachung des Spulenwiderstands (Rs) und
   d) Überwachung und Auswertung der Polarität der elektrischen Leistung der zumindest zwei Verbraucher (3).

6. Verfahren nach Anspruch 4 oder 5, wobei

nach Schritt a) und vor Schritt b) das Einschwingen des resultierenden Stroms ($I_S$) abgewartet wird, oder
nach Schritt aa) und vor Schritt bb) das Einschwingen das Gleichstroms (I) abgewartet wird.

7. Verfahren nach Anspruch 4 oder 6, wobei in Schritt a) eine Gleichspannung ($U_G$) angelegt wird.

8. Verfahren nach einem der Ansprüche 4, 6 oder 7, wobei Schritt b) die Teilschritte umfasst

   b1) Trennen des resultierenden Stroms ($I_S$) in einen Messgleichstrom ($I_G$) und einen Messwechselstrom ($I_W$) mittels eines Filters (7),
   b2) Ermitteln des Spulenwiderstands ($R_S$) aus dem Messgleichstrom ($I_G$) und der angelegten Gleichspannung ($U_G$)

9. Verfahren nach einem der Ansprüche 4 bis 8, wobei Schritt c) die Teilschritte umfasst

   c1) Festlegen eines tolerierbaren Bereichs ($\Delta R_S$) des Spulenwiderstands ($R_S$),
   c2) Abgleichen des in Schritt b) ermittelten Spulenwiderstands (Rs) mit dem tolerierbaren Bereich ($\Delta R_S$),
   c3) Ausgeben zumindest eines Signals, falls der ermittelte Spulenwiderstand ($R_S$) außerhalb des tolerierbaren Bereich ($\Delta R_S$) liegt.

10. Verfahren nach Anspruch 4, wobei In Schritt a) eine Wechselspannung angelegt wird, die eine Frequenz hat, die sich von der oder den Frequenzen des zumindest einen Verbrauchers (3) unterscheidet.

Fig. 1

Fig. 2

EP 2 869 072 A1

Fig. 3a

Fig. 3b

Fig. 3c

**Europäisches Patentamt**
**European Patent Office**
**Office européen des brevets**

# EUROPÄISCHER RECHERCHENBERICHT

**Nummer der Anmeldung**

EP 14 00 3690

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | DE 10 2010 038894 A1 (SIEMENS AG [DE]) 9. Februar 2012 (2012-02-09) | 1-3 | INV. |
| Y | * Absatz [0038] - Absatz [0045] * | 4-10 | G01R11/25 |
|  | ----- |  | G01R35/02 |
| Y | DE 12 30 905 B (SIEMENS AG) 22. Dezember 1966 (1966-12-22) | 4-10 | |
| A | * Spalte 3, Zeile 16 - Spalte 4, Zeile 24 * | 1-3 | |
|  | ----- |  | |
| A | DE 102 04 425 A1 (VACUUMSCHMELZE GMBH & CO KG [DE]) 28. August 2003 (2003-08-28) * Absatz [0020] - Absatz [0024] * | 1-10 | |
|  | ----- |  | |
| A | DE 103 10 503 A1 (BOSCH GMBH ROBERT [DE]) 23. September 2004 (2004-09-23) * das ganze Dokument * | 1-10 | |
|  | ----- |  | |

**RECHERCHIERTE SACHGEBIETE (IPC)**

G01R
G01D

Der vorliegende Recherchenbericht wurde für alle Patentansprüche erstellt

| Recherchenort | Abschlußdatum der Recherche | Prüfer |
|---|---|---|
| München | 19. März 2015 | Jedlicska, István |

**ANHANG ZUM EUROPÄISCHEN RECHERCHENBERICHT**
**ÜBER DIE EUROPÄISCHE PATENTANMELDUNG NR.**

EP 14 00 3690

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

19-03-2015

| Im Recherchenbericht angeführtes Patentdokument | Datum der Veröffentlichung | Mitglied(er) der Patentfamilie | Datum der Veröffentlichung |
|---|---|---|---|
| DE 102010038894 A1 | 09-02-2012 | DE 102010038894 A1<br>WO 2012016939 A1 | 09-02-2012<br>09-02-2012 |
| DE 1230905 B | 22-12-1966 | KEINE | |
| DE 10204425 A1 | 28-08-2003 | KEINE | |
| DE 10310503 A1 | 23-09-2004 | KEINE | |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102007047920 A1